(19) Europäisches Patentamt / European Patent Office / Office européen des brevets

(11) EP 4 671 335 A1

(12) **EUROPEAN PATENT APPLICATION**

(43) Date of publication:
**31.12.2025 Bulletin 2026/01**

(21) Application number: **25182987.5**

(22) Date of filing: **16.06.2025**

(51) International Patent Classification (IPC):
***C09J 7/38*** *(2018.01)*

(52) Cooperative Patent Classification (CPC):
**C09J 7/385;** C09J 2203/326; C09J 2433/00; H01L 21/6836; H01L 2221/68327; H01L 2221/6834

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **28.06.2024 JP 2024105698**

(71) Applicant: **Nitto Denko Corporation**
**Ibaraki-shi, Osaka 567-8680 (JP)**

(72) Inventors:
- **Chiba, Mizuho**
**Ibaraki-shi, Osaka, 567-8680 (JP)**
- **Kitagawa, Taiki**
**Ibaraki-shi, Osaka, 567-8680 (JP)**
- **Tsujita, Kakeru**
**Ibaraki-shi, Osaka, 567-8680 (JP)**

(74) Representative: **Grünecker Patent- und Rechtsanwälte PartG mbB**
**Leopoldstraße 4**
**80802 München (DE)**

(54) **PRESSURE-SENSITIVE ADHESIVE SHEET**

(57) Provided is a pressure-sensitive adhesive sheet that can be suppressed from being increased in peel strength even when an aqueous pressure-sensitive adhesive composition is used. The pressure-sensitive adhesive sheet includes: a base material; and a pressure-sensitive adhesive layer formed of a water-dispersed pressure-sensitive adhesive composition containing a water-dispersed polymer. A surface concentration of a carboxyl group in a surface of the pressure-sensitive adhesive layer obtained by an X-ray photoelectron spectroscopy (ESCA) gas-phase chemical modification method is equal to or less than a detection limit.

FIG.1

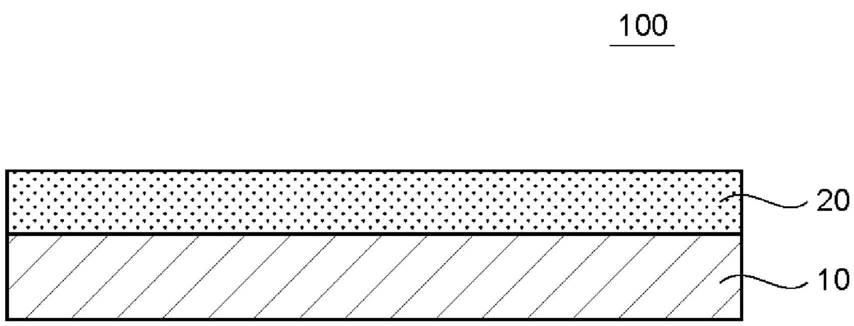




Processed by Luminess, 75001 PARIS (FR)

## Description

### BACKGROUND OF THE INVENTION

1. Field of the Invention

The present invention relates to a pressure-sensitive adhesive sheet.

2. Description of the Related Art

A pressure-sensitive adhesive sheet has been widely used for the purposes of surface protection and fixation of an adherend. For example, in a processing process for a semiconductor wafer, the pressure-sensitive adhesive tape is used for appropriately holding the semiconductor wafer serving as the adherend in each of a backgrinding step and a dicing step. The pressure-sensitive adhesive sheet to be used in the processing process for the semiconductor wafer is peeled from the semiconductor wafer after its use, and hence a pressure-sensitive adhesive sheet having re-peelability has been preferably used. A solvent-based pressure-sensitive adhesive has been widely used as a pressure-sensitive adhesive having re-peelability (for example, Japanese Patent Application Laid-open No. 2019-31620). In recent years, a reduction in environmental load has been required, and hence an attempt has been made to use an aqueous pressure-sensitive adhesive (for example, Japanese Patent Application Laid-open No. 2009-73920).

### SUMMARY OF THE INVENTION

The surface of the wafer after the backgrinding step has high activity, and when the pressure-sensitive adhesive sheet is bonded to the activated surface of the wafer after the backgrinding step, a problem may occur in peelability by an interaction between the surface of a pressure-sensitive adhesive layer and the surface of the wafer. When the aqueous pressure-sensitive adhesive is used, the peeling of the pressure-sensitive adhesive sheet from the adherend becomes difficult, and hence the problem of peelability tends to become more remarkable.

1. According to at least one embodiment of the present invention, there is provided a pressure-sensitive adhesive sheet, including: a base material; and a pressure-sensitive adhesive layer formed of a water-dispersed pressure-sensitive adhesive composition containing a water-dispersed polymer, wherein a surface concentration of a carboxyl group in a surface of the pressure-sensitive adhesive layer obtained by an X-ray photoelectron spectroscopy (ESCA) gas-phase chemical modification method is equal to or less than a detection limit.

2. In the pressure-sensitive adhesive sheet according to the above-mentioned item 1, the water-dispersed pressure-sensitive adhesive composition may further contain an active energy ray-curable resin and a photopolymerization initiator.

3. In the pressure-sensitive adhesive sheet according to the above-mentioned item 1 or 2, a monomer composition to be used in polymerization of the water-dispersed polymer may contain a carboxyl group-containing monomer.

4. In the pressure-sensitive adhesive sheet according to the above-mentioned item 3, the monomer composition to be used in the polymerization of the water-dispersed polymer may contain less than 3 parts by weight of the carboxyl group-containing monomer in terms of acrylic acid equivalent with respect to 100 parts by weight of a total of all monomer components.

5. In the pressure-sensitive adhesive sheet according to any one of the above-mentioned items 2 to 4, the active energy ray-curable resin may be a self-emulsifiable aqueous active energy ray-curable resin.

6. The pressure-sensitive adhesive sheet according to any one of the above-mentioned items 1 to 5, the detection limit may be 0.034 atomic%.

7. The pressure-sensitive adhesive sheet according to any one of the above-mentioned items 1 to 6 may be used for semiconductor wafer processing.

8. The pressure-sensitive adhesive sheet according to any one of the above-mentioned items 1 to 6 may be a dicing tape.

According to at least one embodiment of the present invention, there can be provided a pressure-sensitive adhesive sheet suppressed from being increased in peel strength even when bonded to an activated wafer. In addition, a pressure-sensitive adhesive layer is formed with an aqueous pressure-sensitive adhesive, and hence an environmental load can be reduced.

## BRIEF DESCRIPTION OF THE DRAWINGS

FIG. 1 is a schematic sectional view of a pressure-sensitive adhesive sheet according to at least one embodiment of the present invention.

## DESCRIPTION OF THE EMBODIMENTS

### A. Overall Configuration of Pressure-sensitive Adhesive Sheet

A pressure-sensitive adhesive sheet according to at least one embodiment of the present invention includes: a base material; and a pressure-sensitive adhesive layer formed of a water-dispersed pressure-sensitive adhesive composition containing a water-dispersed polymer. A surface concentration of a carboxyl group in a surface of the pressure-sensitive adhesive layer obtained by an X-ray photoelectron spectroscopy (ESCA) gas-phase chemical modification method is equal to or less than a detection limit. When the surface concentration of the carboxyl group obtained by the ESCA gas-phase chemical modification method is equal to or less than the detection limit, an increase in peel strength can be suppressed even when the pressure-sensitive adhesive sheet is bonded to an activated surface of a semiconductor wafer. In an aqueous pressure-sensitive adhesive such as a water-dispersed pressure-sensitive adhesive composition, a monomer component having a carboxyl group may be used in the polymerization of a base polymer to impart mechanical stability. A polar group such as a carboxyl group is liable to cause an interaction with the activated surface of the semiconductor wafer, and hence the increase in peel strength may become more remarkable. It has been known that an active energy ray-curable pressure-sensitive adhesive is used as a method of making the pressure-sensitive adhesive sheet lightly peelable. When the water-dispersed pressure-sensitive adhesive composition is used, it may be difficult to sufficiently make the pressure-sensitive adhesive sheet lightly peelable even in the case of adopting the active energy ray-curable pressure-sensitive adhesive. In the pressure-sensitive adhesive sheet according to at least one embodiment of the present invention, the surface concentration of the carboxyl group in the surface of the pressure-sensitive adhesive layer obtained by the ESCA gas-phase chemical modification method is equal to or less than the detection limit. When the surface concentration of the carboxyl group is equal to or less than the detection limit, the increase in peel strength due to the interaction between the surface of the pressure-sensitive adhesive layer and the activated surface of the semiconductor wafer can be suppressed. Accordingly, a semiconductor wafer reduced in thickness and size can be suppressed from being broken at the time of the peeling of the pressure-sensitive adhesive sheet. In addition, an aqueous pressure-sensitive adhesive is used as a pressure-sensitive adhesive, and hence environmental load can be reduced.

FIG. 1 is a schematic sectional view of a pressure-sensitive adhesive sheet according to at least one embodiment of the present invention. A pressure-sensitive adhesive sheet 100 includes a base material 20 and a pressure-sensitive adhesive layer 10 in the stated order. The pressure-sensitive adhesive layer 10 is formed by using a water-dispersed pressure-sensitive adhesive composition. As described above, the surface concentration of the carboxyl group in the surface of the pressure-sensitive adhesive layer of the pressure-sensitive adhesive sheet according to at least one embodiment of the present invention obtained by the X-ray photoelectron spectroscopy (ESCA) gas-phase chemical modification method is equal to or less than a detection limit. With such pressure-sensitive adhesive layer **10,** an increase in peel strength can be suppressed even when the pressure-sensitive adhesive sheet is bonded to the activated surface of the wafer. The pressure-sensitive adhesive sheet **100** may further include any appropriate layer. For example, an intermediate layer (not shown) may be formed between the base material **20** and the pressure-sensitive adhesive layer **10.** When the sheet includes the intermediate layer, adhesiveness to an adherend having unevenness on its surface can be improved.

As described above, the surface concentration of the carboxyl group in the surface of the pressure-sensitive adhesive layer obtained by the X-ray photoelectron spectroscopy (ESCA) gas-phase chemical modification method is equal to or less than the detection limit. Even in the case where the pressure-sensitive adhesive uses, for example, a carboxyl group-containing monomer in the polymerization of the base polymer, when the concentration of the carboxyl group in the surface of the pressure-sensitive adhesive layer is equal to or less than the detection limit, the interaction between the surface of the pressure-sensitive adhesive layer and the activated surface of the wafer serving as an adherend is suppressed, and hence the increase in peel strength of the pressure-sensitive adhesive sheet can be suppressed. In addition, when the pressure-sensitive adhesive sheet is stored for a long period of time under a state in which the pressure-sensitive adhesive sheet and the semiconductor wafer are laminated, the increase in peel strength is

more liable to proceed. When the pressure-sensitive adhesive sheet according to at least one embodiment of the present invention is adopted, the increase in peel strength can be suppressed even when the pressure-sensitive adhesive sheet is left to stand under a high-temperature state under a state in which the pressure-sensitive adhesive sheet and the semiconductor wafer are laminated. Herein, the surface concentration of the carboxyl group obtained by the ESCA gas-phase chemical modification method refers to a carboxyl group concentration measured by the following method. The detection limit when the measurement is performed by this method is 0.034 atomic%. Accordingly, in the pressure-sensitive adhesive sheet according to at least one embodiment of the present invention, the surface concentration of the carboxyl group in the surface of the pressure-sensitive adhesive layer obtained by the X-ray photoelectron spectroscopy (ESCA) gas-phase chemical modification method may be 0.034 atomic% or less.

<Gas-phase Chemical Modification ESCA Measurement>

When a release liner is bonded to the pressure-sensitive adhesive layer, the release liner is peeled from the pressure-sensitive adhesive sheet. The surface of the pressure-sensitive adhesive layer of the pressure-sensitive adhesive sheet is subjected to chemical modification with trifluoroethanol. Next, ESCA measurement is performed under the conditions of Table 1 below. The detection limit in this measurement method was 0.034 atomic%.

Table 1

| | |
|---|---|
| Sample preparation | Each sample was cut out into a size of about 1 cm square, and was fixed onto a sample stage by being pressed. |
| Evaluation method | The outermost surface was subjected wide-scan measurement, and qualitative analysis was performed.<br>A COOH group was subjected to narrow-scan measurement, and an elemental ratio (atomic%) was calculated. |
| Apparatus | Manufactured by ULVAC-PHI, Inc., product name: "Quantera SXM" |
| X-ray source | Monochromatic Al Kα |
| X-ray setting | 100 μmΦ [15 kV, 25 W] |
| Photoelectron extraction angle | 45° with respect to a sample surface |
| Neutralization condition | Combined use of a neutralization gun and an Ar ion gun (neutralization mode) |
| Correction of binding energy | A peak derived from a C-C bond in a C1s spectrum is corrected to 285.0 ev. |

In the pressure-sensitive adhesive sheet, the pressure-sensitive adhesive strength to an activated Si wafer of the pressure-sensitive adhesive sheet before active energy ray irradiation is preferably 2 N/20 mm or more, more preferably 3 N/20 mm or more. When the pressure-sensitive adhesive strength to the activated Si wafer of the pressure-sensitive adhesive sheet before the active energy ray irradiation falls within the above-mentioned ranges, the pressure-sensitive adhesive sheet has sufficient adhesiveness to an adherend. In addition, the pressure-sensitive adhesive strength to the activated Si wafer is, for example, 15 N/20 mm or less. Herein, the pressure-sensitive adhesive strength to the activated Si wafer refers to a pressure-sensitive adhesive strength measured by the following method. The pressure-sensitive adhesive sheet is cut out into a size of 20 mm wide by 80 mm long. The semiconductor wafer is subjected to backgrinding under the following conditions. The pressure-sensitive adhesive sheet is pressure-bonded to the backgrinding treatment surface of a silicon mirror wafer within 5 minutes after the backgrinding step by reciprocating a hand roller once under an atmosphere at 23°C. After that, a strength required for peeling the pressure-sensitive adhesive sheet is measured by performing a 90° peeling test at a tensile rate of 300 mm/min under an atmosphere at 23°C and 50%RH.

<Backgrinding Conditions>

Grinder: manufactured by DISCO Corporation, product name: "DFG-840"
First axis: #600 grinding stone (rotation speed: 4,800 rpm, down speed: P1: 3.0 μm/sec, P2: 2.0 μm/sec)
Second axis: #4000 grinding stone (rotation speed: 5,500 rpm, down speed: P1: 0.8 μm/sec, P2: 0.6 μm/sec)

The pressure-sensitive adhesive strength to the activated Si wafer of the pressure-sensitive adhesive sheet after the sheet has been subjected to UV irradiation so as to achieve an integrated light quantity of 460 $mJ/cm^2$ is preferably less

than 0.4 N/20 mm, more preferably 0.35 N/20 mm or less, still more preferably 0.3 N/20 mm or less. When the pressure-sensitive adhesive strength to the activated Si wafer after the irradiation with UV light serving as an active energy ray falls within the above-mentioned ranges, the pressure-sensitive adhesive sheet can have light peelability. The pressure-sensitive adhesive strength after the active energy ray (UV) irradiation is preferably as small as possible. Herein, the pressure-sensitive adhesive strength to the activated Si wafer of the pressure-sensitive adhesive sheet after the sheet has been subjected to the UV irradiation so as to achieve an integrated light quantity of 460 $mJ/cm^2$ refers to a value measured by the following method. The pressure-sensitive adhesive sheet is cut out into a size of 20 mm wide by 80 mm long. The semiconductor wafer is subjected to backgrinding under the following conditions. The pressure-sensitive adhesive sheet is pressure-bonded to the backgrinding treatment surface of a silicon mirror wafer within 5 minutes after the backgrinding step by reciprocating a hand roller once under an atmosphere at 23°C. After that, the resultant is left to stand for 30 minutes. After that, UV light is radiated from a pressure-sensitive adhesive layer side so as to achieve an integrated light quantity of 460 $mJ/cm^2$ (365 nm conversion). Next, a strength required for peeling the pressure-sensitive adhesive sheet is measured by performing a 180° peeling test under an atmosphere at 23°C and 50%RH and under the condition of a tensile rate of 300 mm/min.

<Backgrinding Conditions>

Grinder: manufactured by DISCO Corporation, product name: "DFG-840"
First axis: #600 grinding stone (rotation speed: 4,800 rpm, down speed: P1: 3.0 μm/sec, P2: 2.0 μm/sec)
Second axis: #4000 grinding stone (rotation speed: 5,500 rpm, down speed: P1: 0.8 μm/sec, P2: 0.6 μm/sec)

The pressure-sensitive adhesive strength to the activated Si wafer of the pressure-sensitive adhesive sheet measured after the sheet has been stored under heating at 50°C for 1 week and then irradiated with UV light so as to achieve an integrated light quantity of 460 $mJ/cm^2$ is preferably less than 0.4 N/20 mm, more preferably 0.35 N/20 mm or less, still more preferably 0.3 N/20 mm or less. When the pressure-sensitive adhesive strength to the activated Si wafer of the pressure-sensitive adhesive sheet after the sheet has been stored under heating at 50°C for 1 week and then irradiated with UV light serving as the active energy ray falls within the above-mentioned ranges, the pressure-sensitive adhesive sheet can have light peelability. The pressure-sensitive adhesive strength after the active energy ray (UV) irradiation is preferably as small as possible. Herein, the pressure-sensitive adhesive strength to the activated Si wafer of the pressure-sensitive adhesive sheet after the sheet has been subjected to the UV irradiation so as to achieve an integrated light quantity of 460 $mJ/cm^2$ refers to a value measured by the following method. The pressure-sensitive adhesive sheet is cut out into a size of 20 mm wide by 80 mm long. The semiconductor wafer is subjected to backgrinding under the following conditions. The pressure-sensitive adhesive sheet is pressure-bonded to the backgrinding treatment surface of a silicon mirror wafer within 5 minutes after the backgrinding step by reciprocating a hand roller once under an atmosphere at 23°C. After that, the resultant is left to stand at 50°C for 1 week. After that, UV light is radiated from a pressure-sensitive adhesive layer side so as to achieve an integrated light quantity of 460 $mJ/cm^2$ (365 nm conversion). Next, a strength required for peeling the pressure-sensitive adhesive sheet is measured by performing a 180° peeling test under an atmosphere at 23°C and 50%RH and under the condition of a tensile rate of 300 mm/min.

<Backgrinding Conditions>

Grinder: manufactured by DISCO Corporation, product name: "DFG-840"
First axis: #600 grinding stone (rotation speed: 4,800 rpm, down speed: P1: 3.0 μm/sec, P2: 2.0 μm/sec)
Second axis: #4000 grinding stone (rotation speed: 5,500 rpm, down speed: P1: 0.8 μm/sec, P2: 0.6 μm/sec)

The thickness of the pressure-sensitive adhesive sheet according to at least one embodiment of the present invention may be set to any appropriate thickness. The thickness of the pressure-sensitive adhesive sheet is preferably from 30 μm to 400 μm, more preferably from 40 μm to 300 μm, still more preferably from 50 μm to 200 μm.

A-1. Base Material

The base material may be formed of any appropriate resin. Specific examples of the resin for forming the base material include polyester-based resins, such as polyethylene naphthalate (PEN), polybutylene terephthalate (PBT), and polybutylene naphthalate (PBN), polyolefin-based resins, such as an ethylenevinyl acetate copolymer, an ethylene-methyl methacrylate copolymer, polyethylene, polypropylene, and an ethylenepropylene copolymer, polyvinyl alcohol, polyvinylidene chloride, polyvinyl chloride, a vinyl chloride-vinyl acetate copolymer, polyvinyl acetate, polyamide, polyimide, celluloses, a fluorine-based resin, polyether, polystyrene-based resins such as polystyrene, polycarbonate, polyether sulfone, and polyetheretherketone. Of those, polyolefin-based resins or polyester-based resins are preferred. Those resins each transmit UV light, and hence the pressure-sensitive adhesive layer can be formed by using an active ray-curable pressure-sensitive adhesive such as a UV-curable pressure-sensitive adhesive to provide a pressure-sensitive adhesive sheet having light peelability.

The base material may further contain another component to the extent that the effects of the present invention are not impaired. Examples of the other component include an antioxidant, a UV absorber, a light stabilizer, a heat stabilizer, and an antistatic agent. With regard to the kind and usage amount of the other component, the component may be used in any appropriate amount in accordance with purposes.

The thickness of the base material is preferably from 30 μm to 200 μm, more preferably from 40 μm to 180 μm, still more preferably from 45 μm to 180 μm.

A-2. Pressure-sensitive Adhesive Layer

The pressure-sensitive adhesive layer of the pressure-sensitive adhesive sheet according to at least one embodiment of the present invention is formed of a water-dispersed pressure-sensitive adhesive composition containing a water-dispersed polymer. To secure the dispersibility of the water-dispersed pressure-sensitive adhesive composition, a base polymer may be designed so as to have a polar group such as a carboxyl group. However, when the pressure-sensitive adhesive sheet is bonded to the surface of the wafer activated by the backgrinding step or the like, the polar group of a component in the pressure-sensitive adhesive layer and the activated surface of the wafer interact with each other, and hence an increase in peel strength may occur. The pressure-sensitive adhesive sheet may be stored under a state of being bonded to the semiconductor wafer. When the pressure-sensitive adhesive sheet and the semiconductor wafer are stored for a long period of time under a state of being bonded to each other, the increase in peel strength is more liable to proceed. As described above, the surface concentration of the carboxyl group in the surface of the pressure-sensitive adhesive layer obtained by the X-ray photoelectron spectroscopy (ESCA) gas-phase chemical modification method is equal to or less than the detection limit. When the surface concentration of the carboxyl group in the surface of the pressure-sensitive adhesive layer is equal to or less than the detection limit, the pressure-sensitive adhesive sheet can be suppressed from being excessively increased in pressure-sensitive adhesive strength and increased in peel strength even when bonded to the activated surface of the wafer. In addition, even when the pressure-sensitive adhesive sheet is stored for a long period of time, an increase in peel strength due to an increase in interaction between the surface of the pressure-sensitive adhesive layer and the activated surface of the wafer can be suppressed. As a result, there can be obtained a pressure-sensitive adhesive sheet that is suppressed in breakage of a wafer or the like and is excellent in pick-up property when, for example, used as a dicing tape.

A-2-1. Water-dispersed Polymer

Any appropriate polymer may be used as the water-dispersed polymer. The water-dispersed polymer may be obtained by subjecting any appropriate monomer component to emulsion polymerization in water. That is, the water-dispersed polymer is an emulsion of any appropriate polymer. A water-dispersed acrylic polymer (hereinafter also referred to as "acrylic polymer") is preferably used as the water-dispersed polymer. The average particle diameter of an acrylic polymer emulsion is preferably from 80 nm to 400 nm, more preferably from 100 nm to 300 nm, still more preferably from 100 nm to 200 nm. Herein, the average particle diameter of the water-dispersed acrylic polymer refers to a volume-based median diameter (D50) measured by a laser diffraction-scattering method.

The glass transition temperature (Tg) of the water-dispersed acrylic polymer is preferably from -40°C to 0°C, more preferably from -40°C to -5°C, still more preferably from -40°C to -10°C. When the glass transition temperature falls within the above-mentioned ranges, there is obtained a pressure-sensitive adhesive composition excellent in adhesiveness to an adherend before UV irradiation when an active energy ray-curable pressure-sensitive adhesive is adopted. In addition, the applicability of the pressure-sensitive adhesive composition to be obtained is improved, and hence a pressure-sensitive adhesive layer excellent in appearance can be formed. As a result, for example, when the pressure-sensitive adhesive sheet is used in a processing process for a semiconductor wafer, water can be suppressed from entering a space between the pressure-sensitive adhesive layer and the adherend to cause wafer chipping and chip fly. Herein, the glass transition temperature of the water-dispersed acrylic polymer refers to a theoretical value calculated by Fox's equation from monomer units for forming each polymer and ratios thereof. The theoretical glass transition temperature determined by Fox's equation may be consistent with an actually measured glass transition temperature determined by a method, such as differential scanning calorimetry (DSC) or dynamic viscoelasticity measurement. As described later, when the theoretical value cannot be calculated, the actually measured glass transition temperature may

be used.

As described below, Fox's equation is a relational equation between the Tg of an acrylic polymer and the glass transition temperature Tgi of a homopolymer obtained by homopolymerizing each of

$$1/Tg=\Sigma(Wi/Tgi)$$

monomers for forming the acrylic polymer: where Tg represents the glass transition temperature (unit: K) of the acrylic polymer, Wi represents the weight fraction (copolymerization ratio on a weight basis) of a monomer "i" in the acrylic polymer, and Tgi represents the glass transition temperature (unit: K) of the homopolymer of the monomer "i".

A value described in any appropriate material may be used as the glass transition temperature of the homopolymer to be used in the calculation of the Tg. For example, for monomers listed below, the following values are used as glass transition temperatures of the homopolymers of the monomers.

| | |
|---|---|
| 2-Ethylhexyl acrylate | -70°C |
| Methyl methacrylate | 8°C |
| Acrylic acid | 106°C |
| Hydroxyethyl methacrylate | 55°C |

A numerical value described in, for example, "Polymer Handbook" (3rd edition, John Wiley & Sons, Inc., 1989) may be used as the glass transition temperature of the homopolymer of a monomer except those listed above. When a plurality of kinds of values are described, the highest value is adopted.

A value obtained by a measurement method described in Japanese Patent Application Laid-open No. 2007-51271 may be used for such a monomer that the glass transition temperature of a homopolymer thereof is not described in the above-mentioned Polymer Handbook. Specifically, 100 parts by weight of the monomer, 0.2 part by weight of azobisisobutyronitrile, and 200 parts by weight of ethyl acetate serving as a polymerization solvent are loaded into a reactor including a temperature gauge, a stirring machine, a nitrogen-introducing tube, and a reflux condenser, and are stirred for 1 hour while a nitrogen gas is flowed in the reactor. After oxygen in a polymerization system has been removed as described above, a temperature in the reactor is increased to 63°C and the mixture is subjected to a reaction for 10 hours. Next, the resultant is cooled to room temperature to provide a homopolymer solution having a solid content concentration of 33 wt%. Next, the homopolymer solution is cast onto a release liner, and is dried to produce a test sample (sheet-shaped homopolymer) having a thickness of about 2 mm. The test sample is punched into a disc shape having a diameter of 7.9 mm. The disc is sandwiched between parallel plates, and its viscoelasticity is measured with a viscoelasticity tester (ARES, manufactured by Rheometric Scientific, Inc.) in the temperature region of from -70°C to 150°C at a rate of temperature increase of 5°C/min by a shear mode while a shear strain having a frequency of 1 Hz is applied to the disc. The peak top temperature of the tan$\delta$ of the disc is defined as the Tg of the homopolymer.

In at least one embodiment of the present invention, the water-dispersed acrylic polymer may be a polymer having a core-shell type structure (hereinafter also referred to as "core-shell polymer"). When the water-dispersed acrylic polymer is a core-shell polymer, a polymer having two or more glass transition temperatures can be easily obtained. When such water-dispersed acrylic polymer serving as a core-shell polymer is adopted, there can be provided a water-dispersed pressure-sensitive adhesive composition that has an excellent pressure-sensitive adhesive strength, and that can achieve both of adhesiveness to an adherend and light peelability.

The water-dispersed acrylic polymer serving as a core-shell polymer is obtained by subjecting any appropriate monomer component to emulsion polymerization in a stepwise manner. The water-dispersed acrylic polymer may be obtained by, for example, subjecting a monomer composition for forming a core portion to emulsion polymerization by any appropriate method, and then subjecting a monomer composition for forming a shell portion to emulsion polymerization in the presence of the generated polymer particles serving as a core portion.

The core ratio of the water-dispersed acrylic polymer serving as a core-shell polymer is preferably 5 wt% or more, more preferably 10 wt% or more. When the weight ratio between the core portion and the shell portion falls within the above-mentioned ranges, there can be provided a water-dispersed pressure-sensitive adhesive composition that has an excellent pressure-sensitive adhesive strength, and that can achieve both of adhesiveness to an adherend and light peelability.

A-2-2. Monomer Component

The monomer composition to be used in the polymerization of the water-dispersed acrylic polymer (formation of a

core portion or a shell portion in the case of a core-shell type polymer) contains any appropriate monomer component. The monomer components may be used alone or in combination thereof.

Any appropriate acrylic monomer may be used as the monomer component. A (meth)acrylic acid alkyl ester is used as a typical monomer component. Specific examples of the (meth)acrylic acid alkyl ester include (meth)acrylic acid C1 to C20 alkyl esters, such as methyl (meth)acrylate, ethyl (meth)acrylate, propyl (meth)acrylate, isopropyl (meth) acrylate, butyl (meth)acrylate, isobutyl (meth)acrylate, s-butyl (meth)acrylate, t-butyl (meth)acrylate, pentyl (meth) acrylate, hexyl (meth)acrylate, heptyl (meth)acrylate, octyl (meth)acrylate, 2-ethylhexyl (meth)acrylate, isooctyl (meth) acrylate, nonyl (meth)acrylate, isononyl (meth)acrylate, decyl (meth)acrylate, isodecyl (meth)acrylate, undecyl (meth) acrylate, dodecyl (meth)acrylate, tridecyl (meth)acrylate, tetradecyl (meth)acrylate, pentadecyl (meth)acrylate, hexadecyl (meth)acrylate, heptadecyl (meth)acrylate, octadecyl (meth)acrylate, nonadecyl (meth)acrylate, and eicoscyl (meth) acrylate. The (meth)acrylic acid alkyl esters may be used alone or in combination thereof. Herein, the term " (meth)acryl" refers to acryl and/or methacryl.

The monomer composition may further contain any appropriate other monomer copolymerizable with the (meth) acrylic acid alkyl ester. Examples thereof include: carboxyl group-containing monomers, such as acrylic acid, methacrylic acid, and a carboxyl group-containing monomer represented by the formula (1) to be described later; acid anhydride monomers, such as maleic anhydride and itaconic anhydride; hydroxyl group-containing monomers including hydroxyalkyl (meth)acrylates, such as 2-hydroxyethyl (meth)acrylate, 2-hydroxypropyl (meth)acrylate, 2-hydroxybutyl (meth) acrylate, 3-hydroxypropyl (meth)acrylate, 4-hydroxybutyl (meth)acrylate, 6-hydroxyhexyl (meth)acrylate, 8-hydroxyoctyl (meth)acrylate, 10-hydroxydecyl (meth)acrylate, 12-hydroxylauryl (meth)acrylate, and (4-hydroxymethylcyclohexyl) methyl (meth)acrylate; sulfonic acid group-containing monomers, such as styrenesulfonic acid and allylsulfonic acid; (N-substituted) amide-based monomers, such as diacetone acrylamide, (meth)acrylamide, and N,N-dimethyl (meth) acrylamide; aminoalkyl (meth)acrylate-based monomers such as aminoethyl (meth)acrylate; alkoxyalkyl (meth)acrylate-based monomers such as methoxyethyl (meth)acrylate; maleimide-based monomers, such as N-cyclohexylmaleimide and N-isopropylmaleimide; itaconimide-based monomers, such as N-methylitaconimide and N-ethylitaconimide; succinimide-based monomers; vinyl-based monomers, such as vinyl acetate, vinyl propionate, N-vinylpyrrolidone, and methylvinylpyrrolidone; cyanoacrylate monomers, such as acrylonitrile and methacrylonitrile; epoxy group-containing acrylic monomers such as glycidyl (meth)acrylate; glycol-based acrylic ester monomers, such as polyethylene glycol (meth)acrylate and polypropylene glycol (meth)acrylate; acrylic acid ester-based monomers each having a heterocycle, a halogen atom, a silicon atom, or the like, such as tetrahydrofurfuryl (meth)acrylate, fluorine (meth)acrylate, and silicone (meth)acrylate; olefin-based monomers, such as isoprene, butadiene, and isobutylene; and vinyl ether-based monomers such as vinyl ether. The incorporation of those monomer components can modify, for example, cohesive strength, heat resistance, or cross-linkability. Those monomer components may be used alone or in combination thereof. The respective monomer components may be used at any appropriate ratios.

The monomer composition preferably contains a carboxyl group-containing monomer. When the carboxyl group-containing monomer is used as a monomer component to be used in the polymerization of the water-dispersed acrylic polymer serving as a base polymer, a base polymer having a carboxyl group is obtained. When the base polymer having a carboxyl group is used, a water-dispersed pressure-sensitive adhesive composition having a stable dispersion state can be obtained. Any appropriate monomer may be used as the carboxyl group-containing monomer. Specific examples thereof include, as described above, acrylic acid, methacrylic acid, and the carboxyl group-containing monomer represented by the formula (1). Those monomers may be used alone or in combination thereof.

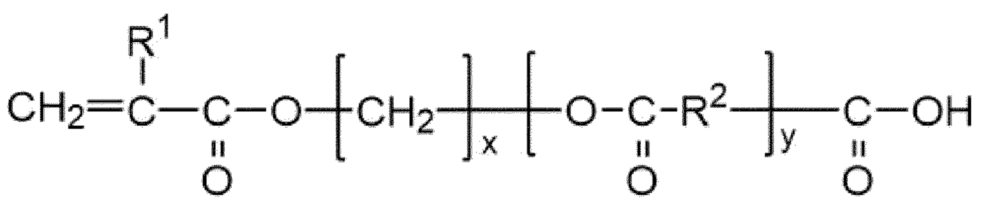 (1)

In the formula, $R^1$ represents a hydrogen atom or a methyl group, $R^2$ represents a divalent hydrocarbon group, "x" represents an integer of from 1 to 20, and "y" represents 0 or 1.

$R^1$ represents a hydrogen atom or a methyl group. "x" represents an integer of from 1 to 20, preferably an integer of from 1 to 10, more preferably an integer of from 1 to 8. "y" represents 0 or 1. $R^2$ represents a divalent hydrocarbon group. Examples of the divalent hydrocarbon group include: saturated aliphatic hydrocarbon groups such as an alkylene group; saturated alicyclic hydrocarbon groups such as a cycloalkylene group; aromatic hydrocarbon groups such as a phenylene group; unsaturated aliphatic hydrocarbon groups; and unsaturated alicyclic hydrocarbon groups. $R^2$ represents preferably a linear or branched alkylene group or a cycloalkylene group, more preferably a linear or branched alkylene group having 1 to 20 carbon atoms or a cycloalkylene group, still more preferably a linear or branched alkylene group having 1 to 10 carbon atoms or a cycloalkylene group. When "x" falls within the above-mentioned ranges and $R^2$ represents the

above-mentioned divalent hydrocarbon group, a pressure-sensitive adhesive excellent in dispersion stability and applicability can be obtained.

Specific examples of the carboxyl group-containing monomer represented by the formula (1) include 2-acryloyloxyethyl succinate, 2-methacryloyloxyethyl succinate, 2-acryloyloxyethyl hexahydrophthalate, ω-carboxy-polycaprolactone (n≈2) monoacrylate, and 2-methacryloyloxyethyl hexahydrophthalate.

A commercially available product may be used as the carboxyl group-containing monomer represented by the formula (1). Examples of the commercially available product include: products available under the product names "HOA-MS", "Light Ester HO-MS(N)", and "Light Acrylate HOA-HH(N)" from Kyoeisha Chemical Co., Ltd.; and a product available under the product name "ARONIX M-5300" from Toagosei Co., Ltd.

The monomer composition to be used in the polymerization of the water-dispersed polymer contains preferably less than 3 parts by weight, more preferably 2.5 parts by weight or less, still more preferably 2 parts by weight or less of the carboxyl group-containing monomer in terms of acrylic acid equivalent with respect to 100 parts by weight of the total of all monomer components. When the content of the carboxyl group-containing monomer in the monomer composition is less than 3 parts by weight in terms of acrylic acid equivalent, a pressure-sensitive adhesive sheet further suppressed from being increased in peel strength can be obtained. The content of the carboxyl group-containing monomer is preferably 1 part by weight or more in terms of acrylic acid equivalent because a water-dispersed pressure-sensitive adhesive composition more excellent in dispersion stability is obtained. Herein, the acrylic acid equivalent of the carboxyl group-containing monomer may be calculated from the molar mass of the carboxyl group-containing monomer and the molar mass of acrylic acid. Specifically, the acrylic acid equivalent refers to a value calculated by the following equation. When the monomer composition contains two or more kinds of carboxyl group-containing monomers, the total of the acrylic acid equivalents of the respective carboxyl group-containing monomers is adopted as the acrylic acid equivalent of the carboxyl group-containing monomer in the monomer composition. In addition, when the water-dispersed acrylic polymer is a core-shell type acrylic polymer, the acrylic acid equivalent refers to the acrylic acid equivalent of the carboxyl group-containing monomer in each of the following monomer compositions: a monomer composition to be used in the formation of a core portion; and a monomer composition to be used in the formation of a shell portion.

Acrylic acid equivalent=molar mass of carboxyl group-containing monomer (g/mol)/molar mass of acrylic acid (72.06 g/mol)

### A-2-3. Surfactant

Any appropriate surfactant may be used as a surfactant to be used in the polymerization of the water-dispersed acrylic polymer. A reactive surfactant may be preferably used. The reactive surfactant has a radically polymerizable functional group (e.g., a radical reactive group, such as an ethenyl group, a propenyl group, an allyl group, or an allyl ether group) in a molecule thereof while having a function as a surfactant. When the reactive surfactant is used, the contamination of an adherend by the pressure-sensitive adhesive in which the water-dispersed acrylic polymer is used can be reduced, and the pressure-sensitive adhesive strength of the pressure-sensitive adhesive composition before radiation irradiation treatment can be improved. In addition, the water resistance of the pressure-sensitive adhesive sheet (e.g., the pressure-sensitive adhesive layer) using the pressure-sensitive adhesive composition is improved, and hence the peeling of the pressure-sensitive adhesive sheet can be suppressed even when the sheet is brought into contact with water at the time of processing.

The reactive surfactant is, for example, a surfactant obtained by introducing a radically polymerizable functional group (radical reactive group), such as a propenyl group or an allyl ether group, to any appropriate surfactant (e.g., an anionic surfactant or a nonionic surfactant). The reactive surfactant has a radically polymerizable functional group according to an ethylenically unsaturated double bond, and can reduce the saturated water absorption ratio of the pressure-sensitive adhesive layer to be formed as compared to a nonreactive surfactant. Further, the reactive surfactants to be preferably used may be used alone or in combination thereof from the viewpoints of the stability of a water dispersion liquid and the durability of the pressure-sensitive adhesive layer.

Specific examples of the anionic surfactant include: higher fatty acid salts such as sodium oleate; alkylaryl sulfonic acid salts such as sodium dodecylbenzene sulfonate; alkyl sulfuric acid ester salts, such as sodium lauryl sulfate and ammonium lauryl sulfate; polyoxyethylene alkyl ether sulfuric acid ester salts such as sodium polyoxyethylene lauryl ether sulfate; polyoxyethylene alkylaryl ether sulfuric acid ester salts such as sodium polyoxyethylene nonylphenyl ether sulfate; alkyl sulfosuccinic acid ester salts and derivatives thereof, such as sodium monooctyl sulfosuccinate, sodium dioctyl sulfosuccinate, and sodium polyoxyethylene lauryl sulfosuccinate; and polyoxyethylene distyrenated phenyl ether sulfuric acid ester salts. Specific examples of the nonionic surfactant include: polyoxyethylene alkyl ethers, such as polyoxyethylene lauryl ether and polyoxyethylene stearyl ether; polyoxyethylene alkylphenyl ethers, such as polyoxyethylene octylphenyl ether and polyoxyethylene nonylphenyl ether; sorbitan higher fatty acid esters, such as sorbitan monolaurate, sorbitan monostearate, and sorbitan trioleate; polyoxyethylene sorbitan higher fatty acid esters such as polyoxyethylene sorbitan monolaurate; polyoxyethylene higher fatty acid esters, such as polyoxyethylene monolaurate

and polyoxyethylene monostearate; glycerin higher fatty acid esters, such as oleic acid monoglyceride and stearic acid monoglyceride; and a polyoxyethylene-polyoxypropylene-block copolymer and polyoxyethylene distyrenated phenyl ether.

A commercially available product may be used as the reactive surfactant. Specific examples of the anionic reactive surfactant include: alkyl ether-based reactive surfactants, such as products available under the product names "AQUALON KH-05", "AQUALON KH-10", and "AQUALON KH-20" fromDKS Co. Ltd., products available under the product names "ADEKA REASOAP SR-10N" and "ADEKA REASOAP SR-20N" from Asahi Denka Co., Ltd., and a product available under the product name "LATEMUL PD-104" from Kao Corporation; sulfosuccinic acid ester-based reactive surfactants, such as products available under the product names "LATEMUL S-120", "LATEMUL S-120A", "LATEMUL S-180P", and "LATEMUL S-180A" from Kao Corporation, and a product available under the product name "ELEMINOL JS-20" from Sanyo Chemical Industries, Ltd.; alkylphenyl ether-based or alkylphenyl ester-based reactive surfactants, such as products available under the product names "AQUALON H-2855A", "AQUALON H-3855B", "AQUALON H-3855C", "AQUALON H-3856", "AQUALON HS-05", "AQUALON HS-10", "AQUALON HS-20", "AQUALON HS-30", "AQUALON BC-05", "AQUALON BC-10", and "AQUALON BC-20" from DKS Co. Ltd., and products available under the product names "ADEKA REASOAP SDX-222", "ADEKA REASOAP SDX-223", "ADEKA REASOAP SDX-232", "ADEKA REASOAP SDX-233", "ADEKA REASOAP SDX-259", "ADEKA REASOAP SE-10N", and "ADEKA REASOAP SE-20N" from Asahi Denka Co., Ltd.; (meth)acrylate sulfuric acid ester-based reactive surfactants, such as products available under the product names "ANTOX MS-60" and "ANTOX MS-2N" from Nippon Nyukazai Co., Ltd., and a product available under the product name "ELEMINOL RS-30" from Sanyo Chemical Industries, Ltd.; and phosphoric acid ester-based reactive surfactants, such as a product available under the product name "H-3330PL" from DKS Co. Ltd., and a product available under the product name "ADEKA REASOAP PP-70" from Asahi Denka Co., Ltd. Specific examples of the nonionic reactive surfactant include: alkyl ether-based reactive surfactants, such as products available under the product names "ADEKA REASOAP ER-10", "ADEKA REASOAP ER-20", "ADEKA REASOAP ER-30", and "ADEKA REASOAP ER-40" from Asahi Denka Co., Ltd., and products available under the product names "LATEMUL PD-420", "LATEMUL PD-430", and "LATEMUL PD-450" from Kao Corporation; alkylphenyl ether-based or alkylphenyl ester-based reactive surfactants, such as products available under the product names "AQUALON RN-10", "AQUALON RN-20", "AQUALON RN-30", and "AQUALON RN-50" from DKS Co. Ltd., and products available under the product names "ADEKA REASOAP NE-10", "ADEKA REASOAP NE-20", "ADEKA REASOAP NE-30", and "ADEKA REASOAP NE-40" from Asahi Denka Co., Ltd.; and (meth)acrylate sulfuric acid ester-based reactive surfactants, such as products available under the product names "RMA-564", "RMA-568", and "RMA-1114" from Nippon Nyukazai Co., Ltd.

The anionic reactive surfactant is preferably used as the reactive surfactant. The anionic reactive surfactant is preferred because the surfactant is excellent in polymerization stability in many cases, and from the viewpoints of particle stability and appearance. The anionic reactive surfactant and the nonionic reactive surfactant may be used in combination.

In at least one embodiment of the present invention, the reactive surfactant preferably has a concentration of a $SO_4^{2-}$ ion of 100 $\mu$g/g or less. In addition, the reactive surfactant is preferably an ammonium salt-type surfactant. The pressure-sensitive adhesive sheet according to at least one embodiment of the present invention may be a pressure-sensitive adhesive sheet to be used in a processing process for a semiconductor wafer. Accordingly, an impurity ion in the pressure-sensitive adhesive may be a problem. Accordingly, the content of the impurity ion in the pressure-sensitive adhesive is preferably as low as possible. When the concentration of the $SO_4^{2-}$ ion falls within the above-mentioned range, and when the ammonium salt-type surfactant is used, adverse effects of the impurity ion can be suppressed. Any appropriate method, such as an ionexchange resin method, a membrane separation method, or a method of precipitating and filtering an impurity with an alcohol, may be used as a method of reducing or removing the impurity ion.

The reactive surfactant is used in any appropriate amount. The content of the reactive surfactant is preferably from 0.1 part by weight to 5 parts by weight, more preferably from 0.5 part by weight to 3 parts by weight with respect to 100 parts by weight of the monomer composition. When the content of the reactive surfactant is more than 5 parts by weight with respect to 100 parts by weight of the monomer composition, in the case where the pressure-sensitive adhesive composition is used for a pressure-sensitive adhesive sheet for semiconductor wafer processing, a small element piece may be peeled from the pressure-sensitive adhesive sheet in a dicing step or a subsequent step. In addition, when the content of the reactive surfactant is less than 0.1 part by weight with respect to 100 parts by weight of the monomer composition, a stable emulsion state may not be maintained.

In addition, the reactive surfactant and a surfactant free of any radically polymerizable functional group may be used in combination. Examples of the surfactant free of any radically polymerizable functional group include: anionic surfactants or nonionic anionic surfactants, such as sodium lauryl sulfate, ammonium lauryl sulfate, sodium dodecylbenzene sulfonate, a sodium polyoxyethylene alkyl ether sulfate, an ammonium polyoxyethylene alkylphenyl ether sulfate, a sodium polyoxyethylene alkylphenyl ether sulfate, and a sodium polyoxyethylene alkyl sulfosuccinate; and nonionic surfactants, such as a polyoxyethylene alkyl ether, a polyoxyethylene alkylphenyl ether, a polyoxyethylene fatty acid ester, and a polyoxyethylene polyoxypropylene block polymer. Those surfactants may be used alone or in combination thereof.

A-2-4. Method of polymerizing Water-dispersed Acrylic Polymer

The water-dispersed acrylic polymer may be polymerized by any appropriate method. For example, the water-dispersed acrylic polymer may be obtained by adding water such as ion-exchanged water, a monomer composition, a surfactant, a polymerization initiator, and any appropriate additive to a reaction vessel, followed by mixing, and performing emulsion polymerization. When the water-dispersed acrylic polymer is a core-shell polymer, the water-dispersed acrylic polymer serving as a core-shell polymer may be obtained, for example, by: loading and mixing a monomer composition containing monomers for forming a core portion, water, a surfactant, a polymerization initiator, and any appropriate additive in a reaction vessel, followed by emulsion polymerization to form polymer particles serving as a core portion; and then loading and mixing a monomer composition containing monomers for forming a shell portion, water, a surfactant, a polymerization initiator, and any appropriate additive in the reaction vessel, followed by emulsion polymerization to form a shell portion. Examples of the any appropriate additive include a chain transfer agent and a silane coupling agent.

Any appropriate polymerization initiator may be used as the polymerization initiator. Examples thereof include: azo-based polymerization initiators, such as 2,2'-azobisisobutyronitrile, 2,2'-azobis(2-amidinopropane) dihydrochloride, 2,2'-azobis[2-(5-methyl-2-imidazolin-2-yl)propane] dihydrochloride, 2,2'-azobis(2-methylpropionamidine) disulfate, and 2,2'-azobis(N,N'-dimethyleneisobutylamidine); persulfates, such as potassium persulfate and ammonium persulfate; peroxide-based polymerization initiators, such as benzoyl peroxide, t-butyl hydroperoxide, and hydrogen peroxide; and redox-based initiators each based on a combination of a peroxide and a reducing agent [e.g., redox-based polymerization initiators based on a combination of a peroxide and ascorbic acid (e.g., a combination of hydrogen peroxide water and ascorbic acid), a combination of a peroxide and an iron(II) salt (e.g., a combination of hydrogen peroxide water and an iron(II) salt), and a combination of a persulfate and sodium hydrogen sulfite]. The polymerization initiators may be used alone or in combination thereof.

The polymerization initiator may be used in any appropriate amount in accordance with, for example, the kind of the polymerization initiator to be used and the composition of the monomer composition. The content of the polymerization initiator is, for example, from 0.01 part by weight to 1 part by weight, preferably from 0.02 part by weight to 0.5 part by weight with respect to 100 parts by weight of the monomer composition.

The chain transfer agent may be used for, for example, adjusting the molecular weight of the water-dispersed acrylic polymer. Any appropriate chain transfer agent may be used as the chain transfer agent. Specific examples thereof include lauryl mercaptan, glycidyl mercaptan, mercaptoacetic acid, 2-mercaptoethanol, thioglycolic acid, 2-ethylhexyl thioglycolate, and 2,3-dimercapto-1-propanol. The chain transfer agents may be used alone or in combination thereof. The content of the chain transfer agent is typically from 0.001 part by weight to 0.5 part by weight with respect to 100 parts by weight of the monomer composition.

The water-dispersed acrylic polymer is obtained by subjecting the monomer composition, the reactive surfactant, the polymerization initiator, and any appropriate additive such as the chain transfer agent to emulsion polymerization. Accordingly, the water-dispersed acrylic polymer may be prepared in the form of an emulsion. Any appropriate method may be used as a method for the emulsion polymerization. A specific example thereof is an emulsion polymerization method utilizing a general method, such as a collective loading method (collective polymerization method), a monomer dropping method, or a monomer emulsion dropping method. When a monomer or the like is dropped, the monomer may be continuously dropped or may be dividedly dropped. A polymerization temperature may be set to any appropriate value in accordance with, for example, the kind of the polymerization initiator, and may be set to, for example, the range of from 5°C to 100°C. In addition, an alkali aqueous solution, such as ammonia water, any of various water-soluble amines, a sodium hydroxide aqueous solution, or a potassium hydroxide aqueous solution, is preferably further added to a solution of the water-dispersed acrylic polymer obtained by the emulsion polymerization to adjust the pH to, for example, from 6 to 11, preferably from 7 to 10.

The gel fraction of the water-dispersed acrylic polymer is preferably 50 wt% or more, more preferably 70 wt% or more. When the gel fraction of the water-dispersed acrylic polymer is less than 50 wt%, a pressure-sensitive adhesive strength after active energy ray irradiation is hardly reduced, and the contamination of an adherend by a sol content is liable to occur. The gel fraction of the water-dispersed acrylic polymer is, for example, 99 wt% or less. The gel fraction of the water-dispersed acrylic polymer may be determined by any appropriate method. For example, the gel fraction may be determined as an insoluble content with respect to a solvent such as ethyl acetate. Specifically, the gel fraction is determined as the weight fraction (unit: wt%) of an insoluble component after the immersion of the water-dispersed acrylic polymer in ethyl acetate at 23°C for 7 days with respect to a sample before the immersion.

A-3. Active Energy Ray-curable Resin

The water-dispersed pressure-sensitive adhesive composition to be used in the present invention may further contain an active energy ray-curable resin and a photopolymerization initiator. When the water-dispersed pressure-sensitive adhesive composition contains the active energy ray-curable resin and the photopolymerization initiator, a water-dispersed pressure-sensitive adhesive composition serving as an active energy ray-curable pressure-sensitive adhesive composition can be obtained. The water-dispersed pressure-sensitive adhesive composition may not be able to be sufficiently made lightly peelable even when the active energy ray-curable pressure-sensitive adhesive is adopted. With the pressure-sensitive adhesive sheet according to at least one embodiment of the present invention, in which the water-dispersed pressure-sensitive adhesive composition further contains the active energy ray-curable resin and the photopolymerization initiator, a pressure-sensitive adhesive sheet that can be made more lightly peelable even when bonded to the activated surface of the wafer can be obtained.

Any appropriate resin that can be cured by an active energy ray such as UV light may be used as the active energy ray-curable resin. A UV-curable resin is preferably used. For example, a UV-curable monomer and/or oligomer may be used as the UV-curable resin. Examples of the UV-curable monomer include urethane (meth)acrylate, trimethylolpropane tri(meth)acrylate, tetramethylolmethane tetra(meth)acrylate, pentaerythritol tri(meth)acrylate, pentaerythritol tetra(meth)acrylate, dipentaerythritol monohydroxy penta(meth)acrylate, dipentaerythritol hexa(meth)acrylate, and 1,4-butanediol di(meth)acrylate. Examples of the UV-curable oligomer include a urethane-based oligomer, a polyether-based oligomer, a polyester-based oligomer, a polycarbonate-based oligomer, and a polybutadiene-based oligomer. An oligomer having a molecular weight of from about 100 to about 50,000 is preferably used as the oligomer. The monomers and the oligomers may be used alone or in combination thereof. The active energy ray-curable resin may be emulsified with any appropriate surfactant or self-emulsifiable urethane (meth)acrylate as required. When the emulsification is performed, the preparation of the water-dispersed pressure-sensitive adhesive can be easily performed.

A commercially available product may be used as the active energy ray-curable resin. Examples thereof include a product available under the product name "ETERNACOLL UW-9102" from UBE Corporation, a product available under the product name "HYDRAN Exp UV-100S" from DIC Corporation, products available under the product names "BEAMSET EM-90" and "BEAMSET EM-94" from Arakawa Chemical Industries, Ltd., a product available under the product name "UAW-1000W30" from Kyoeisha Chemical Co., Ltd., products available under the product names "UCECOAT 7655", "UCECOAT 7200", and "UCECOAT 7773" from Daicel-Allnex Ltd., and products available under the product names "FOM-03006" and "FOM-03009" from FUJIFILM Wako Pure Chemical Corporation. An aqueous resin (water dispersion of a resin) may be appropriately selected and used from the viewpoint of the compatibility of the active energy ray-curable resin with the water-dispersed acrylic polymer.

The active energy ray-curable resin is preferably a self-emulsifiable aqueous active energy ray-curable resin. When the self-emulsifiable aqueous active energy ray-curable resin is used, a pressure-sensitive adhesive sheet further suppressed from being increased in peel strength of the pressure-sensitive adhesive layer can be obtained.

A commercially available product may be used as the self-emulsifiable aqueous active energy ray-curable resin. An example thereof is a product available under the product name "ETERNACOLL UW-9102" from UBE Corporation.

The active energy ray-curable resin may be used in any appropriate amount in accordance with, for example, the kind of the water-dispersed acrylic polymer. The amount is, for example, preferably from 5 parts by weight to 200 parts by weight, more preferably from 20 parts by weight to 150 parts by weight, still more preferably from 50 parts by weight to 150 parts by weight with respect to 100 parts by weight of the water-dispersed acrylic polymer.

A-4. Photopolymerization Initiator

Any appropriate initiator may be used as the photopolymerization initiator. Examples of the photopolymerization initiator include: acyl phosphine oxide-based photopolymerization initiators, such as ethyl 2,4,6-trimethylbenzylphenyl phosphinate and (2,4,6-trimethylbenzoyl)-phenylphosphine oxide; α-ketol-based compounds, such as 4-(2-hydroxyethoxy)phenyl(2-hydroxy-2-propyl) ketone, α-hydroxy-α,α'-dimethylacetophenone, 2-methyl-2-hydroxypropiophenone, and 1-hydroxycyclohexyl phenyl ketone; acetophenone-based compounds, such as methoxyacetophenone, 2,2-dimethoxy-2-phenylacetophenone, 2,2-diethoxyacetophenone, and 2-methyl-1-[4-(methylthio)-phenyl]-2-morpholinopropane-1; benzoin ether-based compounds, such as benzoin ethyl ether, benzoin isopropyl ether, and anisoin methyl ether; ketal-based compounds such as benzyl dimethyl ketal; aromatic sulfonyl chloride-based compounds such as 2-naphthalenesulfonyl chloride; photoactive oxime-based compounds such as 1-phenone-1,1-propanedione-2-(o-ethoxycarbonyl)oxime; benzophenone-based compounds, such as benzophenone, benzoylbenzoic acid, and 3,3'-dimethyl-4-methoxybenzophenone; thioxanthone-based compounds, such as thioxanthone, 2-chlorothioxanthone, 2-methylthioxanthone, 2,4-dimethylthioxanthone, isopropylthioxanthone, 2,4-dichlorothioxanthone, 2,4-diethylthioxanthone, and 2,4-diisopropylthioxanthone; camphorquinone; halogenated ketones; and acyl phosphonates, and α-hydroxyacetophenones such as 2-hydroxy-1-(4-(4-(2-hydroxy-2-methylpropionyl)benzyl)phenyl)-2-methylpropane-1. The photopolymerization initiators may be used alone or in combination thereof. A photopolymerization initiator that is liquid at room temperature (e.g., 23°C) is preferably used because the photopolymerization initiator is soluble in (compatible with) a water-dispersed acrylic polymer solution.

A commercially available product may be used as the photopolymerization initiator. Examples thereof include products available under the product names "Omnirad 500", "Omnirad TPO-L", "Omnirad MBF", and "Omnirad 1173" from

IGM Resins B.V.

The photopolymerization initiator may be used in any appropriate amount. The content of the photopolymerization initiator is preferably from 0.5 part by weight to 20 parts by weight, more preferably from 1 part by weight to 10 parts by weight with respect to 100 parts by weight of the water-dispersed acrylic polymer. When the content of the photopolymerization initiator is less than 0.5 part by weight, the water-dispersed pressure-sensitive adhesive composition may not be sufficiently cured at the time of UV irradiation. When the content of the photopolymerization initiator is more than 20 parts by weight, the storage stability of the water-dispersed pressure-sensitive adhesive composition may be reduced.

A-5. Cross-linking Agent

In at least one embodiment of the present invention, the pressure-sensitive adhesive composition may further contain a cross-linking agent. When the cross-linking agent is used, the gel fraction of the pressure-sensitive adhesive composition can be adjusted. Any appropriate cross-linking agent may be used as the cross-linking agent. Examples thereof include bifunctional or higher epoxy-based cross-linking agents, isocyanate-based cross-linking agents, carbodiimide-based cross-linking agents, oxazoline-based cross-linking agents, aziridine-based cross-linking agents, melamine resin-based cross-linking agents, metal chelate-based cross-linking agents, peroxide-based cross-linking agents, and hydrazine-based cross-linking agents. The cross-linking agents may be used alone or in combination thereof.

Specific examples of the cross-linking agent include: epoxy-based cross-linking agents, such as N,N,N',N'-tetraglycidyl-m-xylenediamine, 1,3-bis(N,N-glycidylaminomethyl)cyclohexane, and 1,6-hexanediol diglycidyl ether; isocyanate-based cross-linking agents (e.g., blocked isocyanate-based cross-linking agents) such as tolylene diisocyanate (blocked); carbodiimide-based cross-linking agents such as a product available under the product name "CARBODILITE V-01" (from Nisshinbo Chemical Inc.); epoxy-based cross-linking agents, such as polyethylene glycol diglycidyl ether and polyglycerol polyglycidyl ether; water-dispersed isocyanate-based cross-linking agents such as a product available under the product name "ELASTRON BN-69" (from DKS Co. Ltd.); oxazoline-based cross-linking agents such as a product available under the product name "EPOCROS WS-500" (from Nippon Shokubai Co., Ltd.); aziridine-based cross-linking agents such as a product available under the product name "CHEMITITE PZ-33" (from Nippon Shokubai Co., Ltd.); hydrophilically treated carbodiimide-based cross-linking agents such as products available under the product names "CARBODILITE V-02" and "CARBODILITE V-04" (from Nisshinbo Chemical Inc.); cross-linking agents each having an active methylol group or an active alkoxymethyl group including an active methylol such as hexamethylolmelamine and an active alkoxymethyl such as hexamethoxymethylmelamine; metal chelate-based cross-linking agents such as a product available under the product name "ORGATIX AI135" (from Matsumoto Fine Chemical Co., Ltd.); and hydrazine-based cross-linking agents, such as adipic dihydrazide and phthalic dihydrazide.

The content of the cross-linking agent is, for example, from 0.01 part by weight to 10 parts by weight, preferably from 0.05 part by weight to 5 parts by weight, more preferably from 0.1 part by weight to 3 parts by weight with respect to 100 parts by weight of the water-dispersed acrylic polymer. As described above, the water-dispersed pressure-sensitive adhesive composition may be free of any cross-linking agent (that is, the content of the cross-linking agent may be 0 parts by weight).

A-6. Additive

The pressure-sensitive adhesive may contain any appropriate additive as required. Examples of the additive include a catalyst (e.g., a platinum catalyst), a tackifier, a plasticizer, a pigment, a dye, a filler, an age resistor, a conductive material, a UV absorber, a light stabilizer, a peeling modifier, a softener, a flame retardant, and a solvent. The additive is used in any appropriate amount in accordance with purposes.

The thickness of the pressure-sensitive adhesive layer may be set to any appropriate value. The thickness of the pressure-sensitive adhesive layer is preferably from 2 μm to 200 μm, more preferably from 3 μm to 150 μm, still more preferably from 5 μm to 100 μm. When the thickness of the pressure-sensitive adhesive layer falls within the above-mentioned ranges, a sufficient pressure-sensitive adhesive strength to an adherend can be exhibited.

B. Method of producing Pressure-sensitive Adhesive Sheet

The pressure-sensitive adhesive sheet according to at least one embodiment of the present invention may be produced by any appropriate method. The pressure-sensitive adhesive sheet may be obtained, for example, by: applying the pressure-sensitive adhesive to a release liner, followed by drying to form a pressure-sensitive adhesive layer on the release liner; and then transferring the pressure-sensitive adhesive layer to the base material. In addition, the pressure-sensitive adhesive sheet may be obtained by applying the pressure-sensitive adhesive onto the base material, followed by drying. Various methods, such as bar coating, air knife coating, gravure coating, gravure reverse coating, reverse roll coating, lip coating, die coating, dip coating, offset printing, flexographic printing, and screen printing, may each be

adopted as a method of applying the pressure-sensitive adhesive. Any appropriate method may be adopted as a method for the drying.

C. Application of Pressure-sensitive Adhesive Sheet

The pressure-sensitive adhesive sheet according to at least one embodiment of the present invention can be suitably used in a production process for a semiconductor wafer. As described above, the pressure-sensitive adhesive sheet according to at least one embodiment of the present invention can be suppressed from being increased in peel strength of the pressure-sensitive adhesive layer even when bonded to the activated surface of the wafer. Accordingly, the pressure-sensitive adhesive sheet can be suitably used as a pressure-sensitive adhesive sheet to be used by being bonded to the semiconductor wafer after the backgrinding step, such as a dicing tape.

Examples

The present invention is specifically described below by way of Examples, but the present invention is not limited to these Examples. In addition, "part(s)" and "%" in Examples are by weight unless otherwise stated.

[Example 1]

1. Synthesis of Acrylic Polymer A

325 Parts by weight of water, 73 parts by weight of 2-ethylhexyl acrylate (2EHA), 26 parts by weight of methyl methacrylate (MMA), 1 part by weight of acrylic acid (AA), and 4.4 parts by weight of a reactive surfactant (manufactured by Sanyo Chemical Industries, Ltd., product name: "ELEMINOL JS-20") were mixed in a reaction vessel including a condenser, a nitrogen-introducing tube, a temperature gauge, and a stirring device, and the mixture was stirred and emulsified with a homomixer. After that, while the emulsion was stirred, the reaction vessel was purged with nitrogen for 1 hour. Subsequently, an inner bath temperature during polymerization was controlled to 60°C. 0.02 Part by weight of a water-soluble azo initiator (manufactured by FUJIFILM Wako Pure Chemical Corporation, product name: "VA-057") was added thereto to initiate the polymerization. Heating was performed for 2 hours. Thus, a core portion was produced.

Next, 75 parts by weight of water, 46 parts by weight of 2EHA, 53 parts by weight of MMA, 1 part by weight of AA, and 1.6 parts by weight of the reactive surfactant (manufactured by Sanyo Chemical Industries, Ltd., product name: "ELEMINOL JS-20") were mixed, and the mixture was stirred with a homomixer to produce a monomer emulsion for a shell. 0.04 Part by weight of the water-soluble azo initiator (manufactured by FUJIFILM Wako Pure Chemical Corporation, product name: "VA-057") was added to the water-dispersed solution having dispersed therein the core particles. After an induction time period of 10 minutes, the emulsified monomer emulsion solution for a shell was added over 2 hours, and then an aging reaction was further performed for 2 hours. Thus, an emulsion containing an acrylic polymer A was produced.

2. Production of Pressure-sensitive Adhesive Sheet

100 Parts by weight of the resultant emulsion containing the acrylic polymer A was neutralized with 10% ammonia water so as to have a pH of 8, and was mixed with 100 parts by weight of a UV-curable resin (manufactured by UBE Corporation, product name: "ETERNACOLL UW-9102"), 1 part by weight of a cross-linking agent (manufactured by Nisshinbo Chemical Inc., product name: "CARBODILITE V-04"), 3 parts by weight of a photopolymerization initiator (manufactured by IGM Resins B.V., product name: "Omnirad TPO L"), 1 part by weight of a leveling agent (manufactured by DKS Co. Ltd., product name: "NEOCOL SW-C"), and 1 part by weight of a thickener (manufactured by San Nopco Limited, product name: "SN-THICKENER 612") to produce a water-dispersed pressure-sensitive adhesive solution. The resultant pressure-sensitive adhesive solution was applied to the silicone release treatment surface of a polyester film (thickness: 38 μm) subjected to silicone release treatment so that its thickness after drying became 5 μm. The resultant was dried at 125°C for 3 minutes to form a pressure-sensitive adhesive layer. Polyolefin (PO) (thickness: 80 μm) subjected to surface oxidation treatment by corona discharge was bonded to the pressure-sensitive adhesive surface of the pressure-sensitive adhesive layer so that the pressure-sensitive adhesive layer was transferred. Thus, a pressure-sensitive adhesive sheet was produced.

[Example 2]

A core-shell type water-dispersed acrylic polymer B was obtained in the same manner as in Example 1 except that the content of AA to be used in the polymerization of the core portion and the shell portion was changed to 2 parts by

weight. A pressure-sensitive adhesive sheet was obtained in the same manner as in Example 1 except that the resultant acrylic polymer was used.

[Example 3]

A core-shell type water-dispersed acrylic polymer C was obtained in the same manner as in Example 1 except that: the content of AA to be used in the polymerization of the core portion and the shell portion was changed to 2 parts by weight; and 3 parts by weight of hydroxyethyl methacrylate (HEMA) was further added as the monomer to be used for the core portion and the shell portion. A pressure-sensitive adhesive sheet was obtained in the same manner as in Example 1 except that the resultant acrylic polymer was used.

[Example 4]

A pressure-sensitive adhesive solution was produced in the same manner as in Example 2 except that the cross-linking agent was not added. A pressure-sensitive adhesive sheet was obtained in the same manner as in Example 2 except that the produced pressure-sensitive adhesive solution was used.

(Comparative Example 1)

A core-shell type water-dispersed acrylic polymer D was obtained in the same manner as in Example 1 except that the content of AA to be used in the polymerization of the core portion and the shell portion was changed to 3 parts by weight. A pressure-sensitive adhesive sheet was obtained in the same manner as in Example 1 except that the resultant acrylic polymer was used.

(Comparative Example 2)

A pressure-sensitive adhesive sheet was obtained in the same manner as in Example 2 except that UAW-1000W30 (manufactured by Kyoeisha Chemical Co., Ltd., product name: "UAW-1000W30") was used as the UV-curable resin instead of UW-9102.

(Comparative Example 3)

A pressure-sensitive adhesive sheet was obtained in the same manner as in Example 2 except that UV-100S (manufactured by DIC Corporation, product name: "HYDRAN Exp UV-100S") was used as the UV-curable resin instead of UW-9102.

<Evaluation>

The following evaluations were performed by using the pressure-sensitive adhesive sheets used in Examples and Comparative Examples. The results are shown in Table 3.

1. Pick-up (PU) Property Evaluation

The pressure-sensitive adhesive sheet was mounted on the ground surface of a 6-inch silicon wafer (thickness: 100 μm), which had been subjected to backgrinding under the following backgrinding conditions, under an environment at 23°C immediately after grinding (within 5 minutes after the completion of the grinding).

<Backgrinding Conditions>

Grinder: manufactured by DISCO Corporation, product name: "DFG-840"
First axis: #600 grinding stone (rotation speed: 4,800 rpm, down speed: P1: 3.0 μm/sec, P2: 2.0 μm/sec)
Second axis: #4000 grinding stone (rotation speed: 5,500 rpm, down speed: P1: 0.8 μm/sec, P2: 0.6 μm/sec)

Next, the silicon wafer was subjected to dicing under the following dicing conditions to form semiconductor chips.

<Dicing Conditions>

Dicer: manufactured by DISCO Corporation, product name: "DFD-651"
Blade: manufactured by DISCO Corporation, product name: "27HECC"
Blade rotation speed: 40,000 rpm
Dicing speed: 120 mm/sec
Dicing depth: 25 μm
Cut mode: down cut
Dicing size: 5.0 mm×5.0 mm

After the completion of the dicing, the chips were stored under heating at 50°C for 1 week, and were irradiated with UV light (integrated light quantity: 460 mJ/$cm^2$) from the back surface side of the pressure-sensitive adhesive sheet. After that, any appropriate chip was picked up from the pressure-sensitive adhesive sheet under the following pick-up conditions. A case in which the pick-up succeeded was evaluated as "o" (satisfactory), and the other cases were evaluated as "×" (room for improvement).

<Pick-up Conditions>

Die bonder: manufactured by NEC Corporation, product name: "Machinery CPS-100"
Number of pins: 4
Intervals between pins: 3.5 mm×3.5 mm
Pin tip curvature: 0.250 mm
Pin push-up amount: 0.50 mm
Adsorption retention time: 0.2 second
Expanding amount: 3 mm

2. Pressure-sensitive Adhesive Strength

A pressure-sensitive adhesive sheet cut out into a size of 80 mm long by 20 mm wide was bonded to the grinding treatment surface of a 6-inch silicon wafer (thickness: 500 μm), which had been subjected to backgrinding under the following backgrinding conditions, with a 2-kilogram roller under an environment at 23°C immediately after the grinding (within 5 minutes after the completion of the grinding). A pressure-sensitive adhesive strength measured for the pressure-sensitive adhesive sheet 30 minutes after the bonding was defined as "before UV (initial)," a pressure-sensitive adhesive strength measured for the pressure-sensitive adhesive sheet irradiated with UV light (integrated light quantity: 460 mJ/$cm^2$) 30 minutes after the bonding was defined as "after UV," and a pressure-sensitive adhesive strength measured for the pressure-sensitive adhesive sheet stored under heating at 50°C for 1 week and irradiated with UV light (460 mJ/$cm^2$) after the bonding was defined as "after heating and UV." The pressure-sensitive adhesive strengths were each measured by performing a 90° peeling test under an atmosphere at 23°C and 50%RH and under the condition of a tensile rate of 300 mm/min.

<Backgrinding Conditions>

Grinder: manufactured by DISCO Corporation, product name: "DFG-840"
First axis: #600 grinding stone (rotation speed: 4,800 rpm, down speed: P1: 3.0 μm/sec, P2: 2.0 μm/sec)
Second axis: #4000 grinding stone (rotation speed: 5,500 rpm, down speed: P1: 0.8 μm/sec, P2: 0.6 μm/sec)

3. Gas-phase Chemical Modification ESCA Measurement

The release liner was peeled from the pressure-sensitive adhesive sheet, and the surface of the pressure-sensitive adhesive layer of the sheet was subjected to chemical modification with trifluoroethanol. Next, ESCA measurement was performed under the conditions of Table 2 below. A detection limit in this measurement method was 0.034 atomic%.

Table 2

| | |
|---|---|
| Sample preparation | Each sample was cut out into a size of about 1 cm square, and was fixed onto a sample stage by being pressed. |
| Evaluation method | The outermost surface was subjected to wide-scan measurement, and qualitative analysis was performed.<br>A COOH group was subjected to narrow-scan measurement, and an elemental ratio (atomic%) was calculated. |
| Apparatus | Manufactured by ULVAC-PHI, Inc., product name: "Quantera SXM" |
| X-ray source | Monochromatic Al Kα |
| X-ray setting | 100 μmΦ [15 kV, 25 W] |
| Photoelectron extraction angle | 45° with respect to a sample surface |
| Neutralization condition | Combined use of a neutralization gun and an Ar ion gun (neutralization mode) |
| Correction of binding energy | A peak derived from a C-C bond in a C1s spectrum is corrected to 285.0 ev. |

Table 3

| | Base polymer | | UV-curable resin | | Cross-linking agent | | Pressure-sensitive adhesive strength (N/20 mm) | | | Pick-up property | Gas-phase modification ESCA |
|---|---|---|---|---|---|---|---|---|---|---|---|
| | AA | HEMA | Kind | Addition amount (part (s) by weight) | Kind | Addition amount (part (s) by weight) | Before UV (initial) | After UV | After heating and UV | | COOH group [atomic%] |
| Example 1 | 1 part | 0 parts | UW-9102 | 100 parts | V-04 | 1 part | 3.6 | 0.2 | 0.2 | ○ | 0.034 or less |
| Example 2 | 2 parts | 0 parts | UW-9102 | 100 parts | V-04 | 1 part | 4.9 | 0.3 | 0.3 | ○ | 0.034 or less |
| Example 3 | 2 parts | 3 parts | UW-9102 | 100 parts | V-04 | 1 part | 4.9 | 0.3 | 0.3 | ○ | 0.034 or less |
| Example 4 | 2 parts | 0 parts | UW-9102 | 100 parts | - | | 3.6 | 0.2 | 0.2 | ○ | 0.034 or less |
| Comparative Example 1 | 3 parts | 0 parts | UW-9102 | 100 parts | V-04 | 1 part | 3.3 | 0.2 | 1.5 | × | 0.1 |
| Comparative Example 2 | 2 parts | 0 parts | UAW-1000W30 | 100 parts | V-04 | 1 part | 1.9 | 0.2 | 5.6 | × | 0.3 |
| Comparative Example 3 | 2 parts | 0 parts | UV-100S | 100 parts | V-04 | 1 part | 1.8 | 0.5 | 4.7 | × | 0.3 |

In each of the pressure-sensitive adhesive sheets of Examples of the present invention, the content of a carboxyl group (COOH group) in the surface of the pressure-sensitive adhesive layer was equal to or lower than a detection limit (0.034 atomic%). Each of the pressure-sensitive adhesive sheets of Examples of the present invention was suppressed from being excessively increased in pressure-sensitive adhesive strength even when heated and then irradiated with UV light, and was excellent in pick-up property of the semiconductor wafer after the dicing.

The pressure-sensitive adhesive sheet according to at least one embodiment of the present invention can be suitably used in an application for semiconductor wafer processing.

## Claims

1. A pressure-sensitive adhesive sheet, comprising:

   a base material; and
   a pressure-sensitive adhesive layer formed of a water-dispersed pressure-sensitive adhesive composition containing a water-dispersed polymer,
   wherein a surface concentration of a carboxyl group in a surface of the pressure-sensitive adhesive layer obtained by an X-ray photoelectron spectroscopy (ESCA) gas-phase chemical modification method is equal to or less than a detection limit.

2. The pressure-sensitive adhesive sheet according to claim 1, wherein the water-dispersed pressure-sensitive adhesive composition further contains an active energy ray-curable resin and a photopolymerization initiator.

3. The pressure-sensitive adhesive sheet according to claim 1, wherein a monomer composition to be used in polymerization of the water-dispersed polymer contains a carboxyl group-containing monomer.

4. The pressure-sensitive adhesive sheet according to claim 3, wherein the monomer composition to be used in the polymerization of the water-dispersed polymer contains less than 3 parts by weight of the carboxyl group-containing monomer in terms of acrylic acid equivalent with respect to 100 parts by weight of a total of all monomer components.

5. The pressure-sensitive adhesive sheet according to claim 2, wherein the active energy ray-curable resin is a self-emulsifiable aqueous active energy ray-curable resin.

6. The pressure-sensitive adhesive sheet according to claim 1, wherein the detection limit is 0.034 atomic%.

7. The pressure-sensitive adhesive sheet according to any one of claims 1 to 6, wherein the pressure-sensitive adhesive sheet is used for semiconductor wafer processing.

8. The pressure-sensitive adhesive sheet according to any one of claims 1 to 6, wherein the pressure-sensitive adhesive sheet is a dicing tape.

FIG.1

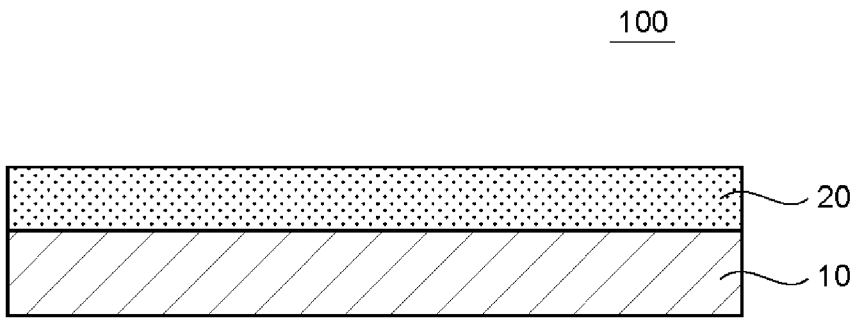

Europäisches Patentamt
European Patent Office
Office européen des brevets

# EUROPEAN SEARCH REPORT

Application Number
EP 25 18 2987

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X<br>A | JP 2023 049165 A (MITSUI CHEMICALS TOHCELLO INC) 10 April 2023 (2023-04-10)<br>* paragraphs [0002], [0034], [0051], [0056], [0065] *<br>* paragraphs [0121], [0122], [0127] *<br>----- | 1-4,6-8<br>5 | INV.<br>C09J7/38 |
| X | EP 3 852 134 A1 (MITSUI CHEMICALS TOHCELLO INC [JP]) 21 July 2021 (2021-07-21)<br>* paragraphs [0002], [0032], [0033], [0112], [0127] *<br>* paragraphs [0133], [0134], [0135], [0143]; example 1 *<br>----- | 1,2,6-8 | |

TECHNICAL FIELDS SEARCHED (IPC)

C09J
H01L

The present search report has been drawn up for all claims

| Place of search | Date of completion of the search | Examiner |
|---|---|---|
| Munich | 17 October 2025 | Alevizopoulou, M |

2

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

# ANNEX TO THE EUROPEAN SEARCH REPORT ON EUROPEAN PATENT APPLICATION NO. EP 25 18 2987

This annex lists the patent family members relating to the patent documents cited in the above-mentioned European search report. The members are as contained in the European Patent Office EDP file on
The European Patent Office is in no way liable for these particulars which are merely given for the purpose of information.

17-10-2025

| Patent document cited in search report | Publication date | Patent family member(s) | Publication date |
|---|---|---|---|
| JP 2023049165 A | 10-04-2023 | JP 7674790 B2 | 12-05-2025 |
| | | JP 2023049165 A | 10-04-2023 |
| EP 3852134 A1 | 21-07-2021 | CN 112673465 A | 16-04-2021 |
| | | EP 3852134 A1 | 21-07-2021 |
| | | KR 20210049860 A | 06-05-2021 |
| | | SG 11202102426T A | 29-04-2021 |
| | | WO 2020053949 A1 | 19-03-2020 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- JP 2019031620 A
- JP 2009073920 A
- JP 2007051271 A


### Non-patent literature cited in the description


- Polymer Handbook. John Wiley & Sons, Inc., 1989